# EUROPÄISCHE PATENTANMELDUNG

(11) **EP 3 796 376 A1**
(43) Veröffentlichungstag der Anmeldung: **24.03.2021**
(21) Anmeldenummer: 20000306.9
(22) Anmeldetag: 25.08.2020
(51) Int. Cl.: H01L 25/065, H01L 25/00, H01L 21/768, H01L 21/822, H01L 23/52, H01L 27/118

(54) **MULTI-DIE-CHIP**

(30) Priorität: 05.09.2019 DE 102019006294
(71) Anmelder: PatForce GmbH, 50670 Köln (DE)
(72) Erfinder:

(57) **Zusammenfassung**

Aufgabe der vorliegenden Erfindung ist es, unterschiedlich große Chips, insbesondere FPGAs, zu realisieren, ohne immer wieder neue Produktions-Maskensätze zu benötigen. Hierbei soll nach herkömmlicher Art ein einzelner Die benutzt werden können oder aber eine fast beliebige Anzahl von Dies aus einem Wafer.

Es wird erfindungsgemäß nur ein Lithographie-Maskensatz für die Chipherstellung benutzt und unterschiedlich große Multi-Die-Chips mit 1..n Einzel-Dies aus einem Wafer herausgetrennt.

Dabei sind die Einzel-Dies über die Trennlinie zwischen den Dies (Scribe Line) verbunden. Nach den Patentansprüchen sind verschiedene Vorkehrungen zu treffen, dass die Dies zuverlässig verbunden sind und bei der Vereinzelung der Multi-Die-Chips keine Probleme auftauchen.

## Beschreibung

Elektronische Bauteile als integrierte Schaltungen, die mehrere Dies, also mehrere Einzelchips beinhalten, sind seit einigen Jahren Stand der Technik. Hier werden durch verschiedene Verbindungstechniken mehrere Chip-Dies so verdrahtet, dass z.B. Mutichipmodule oder Multichipanordnungen in einem gemeinsamen Chip- oder Modulgehäuse realisiert werden können. Gemeinsamkeit dieser Techniken ist, dass einzelne, aus dem jeweiligen Produktionswafer herausgetrennte Chips, meist unterschiedlicher Technologie, verwendet werden.

Bei bestimmten Chip-Gattungen, hier seien exemplarisch sog. FPGAs genannt, möchte man unterschiedlich große Chips mit im Wesentlichen sich wiederholenden Strukturen realisieren. Hierfür benötigt man nach dem Stand der Technik für jede Chipgröße einen eigenen Produktions-Maskensatz, der gerade in heutigen Nanometer-Technologien extrem teuer ist.

Nach dem Stand der Technik ist in dem US-Patent (US 9,147,611 B1) und in der US-Patentanmeldung (US 2015/0171079 A1) bechrieben, dass aus einem Wafer unterschiedlich große, untereinander verbundene, Anordnungen aus mehreren Einzel-Dies mit nur einem Produktionsmaskensatz hergestellt werden können.

Die US-Patentanmeldung (US US2002/0004932 A1) zeigt zusätzlich wie der Sealring am Rande eines Enzel-Dies untertunnelt werden kann.

Aufgabe der vorliegenden Erfindung ist es, unterschiedlich große Chips, insbesondere FPGAs, zu realisieren, ohne immer wieder neue Produktions-Maskensätze zu benötigen und diese über die sog. Scribeline, also den Ritzgraben zwischen den Chips zu verbinden. Hierbei soll nach herkömmlicher Art ein einzelner Die benutzt werden können oder aber eine fast beliebige Anzahl von Dies aus einem Wafer, die dann untereinander eine hohe Zahl von Verbindungen zwischen den Einzeldies realisieren.

Diese Aufgabe wird erfindungsgemäß durch den Gegenstand gemäß Anspruch 1 gelöst.

Entsprechend Anspruch 1 gilt als kennzeichnendes Element der Erfindung, dass nur ein Lithographie-Maskensatz für die Chipherstellung benutzt wird und unterschiedlich große Multi-Die-Chips mit 1..n Einzel-Dies aus einem Wafer herausgetrennt werden.

Im Weiteren befasst sich die Beschreibung der Erfindung und die Ansprüche nur noch mit dem Fall, dass n > 1 ist.

Es werden also mindestens zwei Dies aus einem Wafer benutzt, die nicht vereinzelt wurden. In diesem Fall sind in der Regel keine elektrischen Verbindungen zwischen den Dies vorhanden. Diese können z.B. durch Bonddrähte zwischen den Chips hergestellt werden.

Nachteilig an diesen Verbindungen mit Bonddrähten ist, dass jeweils mindestens ein Eingangs- und Ausgangbuffer benutz wird, was zu erheblichen Signalverzögerungen beim Übergang von einem auf den anderen Chip führt.

Entsprechend dem weiteren Teil von Anspruch 1 wird deshalb erfindungsgemäß vorgeschlagen die Dies direkt im Wafer, also ohne IO-Buffer, zu verbinden.

Da allerdings die Erfindung ja gerade ermöglichen soll, dass angefangen von einem einzigen Die viele verschieden große Multi-Die-Chips realisiert werden können, muss dafür Sorge getragen werden, dass ein Trennen von Dies und damit ein Durchtrennen der im Wafer liegenden Direktverbindungen problemlos möglich ist.

Dies werden üblicher Weise durch Anritzen oder Fräsen und anschließendes Brechen an diesen Sollbruchkanten vereinzelt.

Hier ergeben sich im vorliegenden Fall verschiedene Probleme:
a) Im Bruchbereich entstehen Zerstörungen an der Die-Kante, die im Extremfall dazu führen können, dass verschiedene Verbindungsebene des Chips kurzgeschlossen werden.
b) Durch die Trennung der Leiterbahnen an der Bruchkante floaten die Eingänge mit denen diese Leiterbahnen verbunden sind. Dieses kann zu unnötig hoher Stromaufnahme des Chips führen.

Da in der Regel Dies auf dem Wafer an der Bruchkante keine leitenden Verbindungen haben, taucht das Problem a) bei nicht erfindungsgemäß hergestellten Wafern nicht auf. Entsprechend dem weiteren Teil von Anspruch 1 kann das Problem vermieden werden, wenn an der Bruchkante immer nur eine Verbindungsebene benutzt wird. Dadurch ist ein Kurzschluss mit einer anderen Verbindungsebene ausgeschlossen.

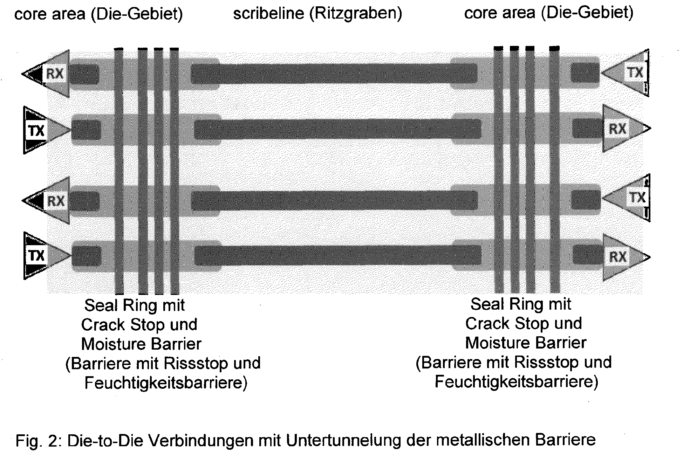

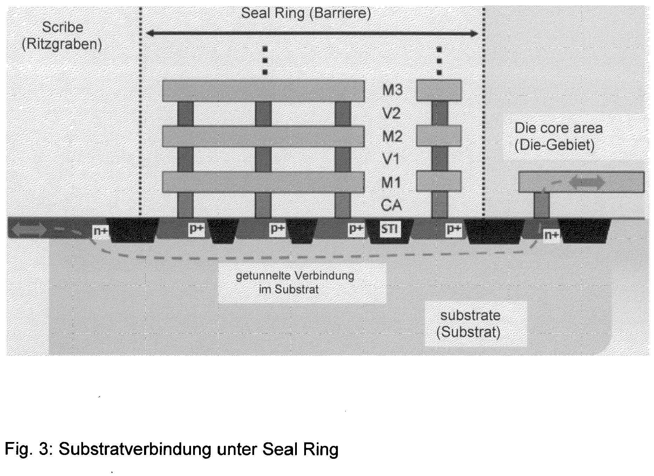

Zusätzlich kann das Problem auch dadurch beseitigt werden, in dem gar keine durchgehenden metallischen Verbindungen zwischen den Dies vorhanden sind. Nach den weiteren Teilen von Anspruch 1 wird hierfür eine im Halbleiter-Substrat liegende Verbindung vorgeschlagen. Dadurch wird die metallische Barriere elektrisch untertunnelt. Diese anspruchsgemäße Ausführung ist in Fig. 3 gezeigt. In ähnlicher Weise kann die Verbindung in der Scribeline zwischen den Dies durch eine niederohmige hochdotierte Verbindung im Halbleiter-Substrat realisiert werden. Diese anspruchsgemäße Ausführung ist in Fig. 2 gezeigt.

Da bei Trennung der Dies elektrische Verbindungen gekappt werden, die danach quasi "in der Luft hängen", wird erfindungsgemäß entsprechend Anspruch 2 durch entsprechende elektronische Schalter und/oder sog. Busholder ein Floaten der gekappten Eingänge vermieden.

Alternativ oder ergänzend dazu wird nach Anspruch 3 ein Kurzschluss von Ausgängen an der Bruchkante dadurch vermieden, dass durch elektronische Schalter ein Signalabschalten der gekappten Verbindungen erreicht wird.

Besonders effizient ist die vorgeschlagene Technik umzusetzen, wenn entsprechend Anspruch 4 und 5 auch über sog. Reticle-Grenzen Verbindungen hergestellt werden.

Dadurch wird es möglich, beliebig große Anordnungen von Dies aus einem Wafer herauszuschneiden, die alle untereinander verbunden sind.

Die bislang aufgeführten Techniken können auch bei Wafern mit unterschiedlichen Chips (z.B. Mutiproject Wafer) angewendet werden. Besonders sinnvoll sind sie entsprechend Anspruch 6 bei einem Wafer mit gleichartigen Dies.

Da Dies nach dem Stand der Technik durch gerade Schnitte aus einem Wafer getrennt werden können, ist entsprechend Anspruch 6 eine rechteckige Anordnung der Dies im Multi-Die-Chip vorteilhaft. Hierdurch ergeben sich folgende typischen Anordnungen:
(<Anzahl in X-Richtung> x <Anzahl in Y-Richtung> : <Anzahl der Dies gesamt>)
1x1: 1
1x2: 2
1x3: 3
2x2: 4
2x3: 6
2x4: 8
3x3: 9
3x4: 12
3x5: 15
3x6: 18
4x4: 16
4x5: 20
4x6: 24
4x8: 32
5x5: 25
5x6: 30
6x6: 36
6x8: 48
8x8: 64

Nach Anspruch 7 ist es auch denkbar unterschiedlich große Dies auf dem Wafer anzuordnen und diese entsprechend zu verbinden. Sinnvoll ist hier insbesondere, wenn diese Einzel-Dies ein Bruchteil oder Vielfaches der Größe der anderen Dies haben.

### Beschreibung der Zeichnungen:

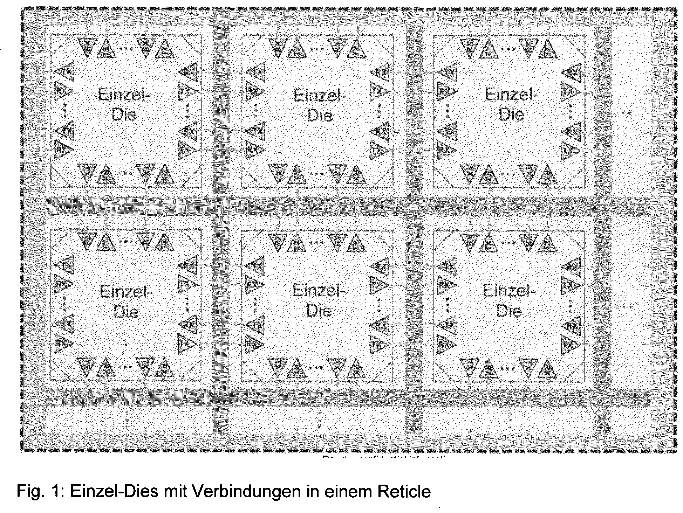

Fig. 1: Einzel-Dies mit Verbindungen in einem Reticle
   Die Zeichnung zeigt die anspruchsgemäße Verbindung einzelner Dies untereinander. Bei einer Anordnung entsprechend Anspruch 7 hat das Reticle die Größe von X mal Y Dies.
Fig. 2: Die-to-Die Verbindungen mit Untertunnelung der metallischen Barriere
   Durch eine Die-to-Die Verbindung werden anspruchsgemäß jeweils 2 Barrieren (Seal Ring) und die Schnittlinie (Scribe Line) zwischen den Dies überbrückt. Die langen Verbindungen in der Scribe Line sind dabei die hoch dotierten Verbindungen nach Anspruch 1.
Fig. 3: Substratverbindung unter Seal Ring
   Diese Zeichnung zeigt einen anspruchsgemäßen Schnitt durch den Wafer am Rande eines Dies. Hier wird gezeigt wie der Seal Ring entsprechend Anspruch 1 untertunnelt wird.

## Patentansprüche

1. Multi-Die-Chip
wobei nur ein Lithographie-Maskensatz für die Chipherstellung benutzt wird und unterschiedlich große Multi-Die-Chips mit 1..n Einzel-Dies aus einem Wafer herausgetrennt werden und
wobei elektrische Verbindungen ohne die Benutzung von IO-Buffern zwischen mindestens zwei der Einzel-Dies vorhanden sind und
wobei jeweils nur eine elektrisch leitfähige Verbindungsebene über den sonst als Trennlinie genutzten Bereich zwischen den Einzel-Dies verläuft und
wobei über eine Substratverbindung die am Rand der Einzel-Dies befindliche metallische Schutzbarriere untertunnelt wird und
wobei ohne Verwendung metallischer Strukturen die eine elektrisch leitfähige Verbindungsebene zwischen den Einzel-Dies durch eine niederohmige hochdotierte Substratverbindung realisiert wird.

2. Multi-Die-Chip nach Anspruch 1 **dadurch gekennzeichnet,**
**dass** durch elektronische Schalter oder Busholder ein Floaten der beim Abtrennen eines Single- oder Multi-Die-Chip aus dem Wafer gekappten Verbindungen vermieden wird.

3. Multi-Die-Chip nach einem oder mehreren der vorausgehenden Ansprüche **dadurch gekennzeichnet,**
**dass** durch elektronische Schalter ein Signalabschalten der beim Abtrennen eines Single- oder Multi-Die-Chip aus dem Wafer gekappten Verbindungen erreicht wird.

4. Multi-Die-Chip nach einem oder mehreren der vorausgehenden Ansprüche **dadurch gekennzeichnet,**
**dass** auch über Reticle-Grenzen die Einzel-Dies in gleicher Weise verbunden sind wie innerhalb eines Reticles.

5. Multi-Die-Chip nach einem oder mehreren der vorausgehenden Ansprüche **dadurch gekennzeichnet,**
**dass** alle Einzel-Dies auf einem Wafer verbunden sind und dadurch beliebig große Anordnungen von Multi-Die-Chips herausgetrennt werden können.

6. Multi-Die-Chip nach einem oder mehreren der vorausgehenden Ansprüche **dadurch gekennzeichnet,**
**dass** der Multi-Die-Chip aus einer rechteckigen Anordnung von mehreren gleichartigen Einzel-Dies besteht.

7. Multi-Die-Chip nach einem oder mehreren der vorausgehenden Ansprüche 1 bis 5 **dadurch gekennzeichnet,**
**dass** der Multi-Die-Chip aus verschieden großen Einzel-Dies besteht.
